# EUROPEAN PATENT SPECIFICATION

(11) **EP 0 913 937 B1**
(45) Date of publication and mention of the grant of the patent: **02.01.2003**
(21) Application number: 98308436.9
(22) Date of filing: 15.10.1998
(51) Int. Cl.: H03K 17/16, H03K 19/003, H03K 19/0185

(54) **Clock driver apparatus with programmable output characteristics**
Takttreibervorrichtung mit programmierbaren Ausgangseingensschaften
Circuit d'attaque d'horloge avec caractéristiques de sortie programmables

(30) Priority: 29.10.1997 US 960408; 29.05.1998 US 86973
(43) Date of publication of application: 06.05.1999
(73) Proprietor: Agilent Technologies, Inc. (a Delaware corporation), Palo Alto, CA 94303 (US)
(72) Inventor: Stephens, Charles S., Corvallis, OR 97330 (US); Davis, Raymond A., Corvallis, OR 97330 (US)
(74) Representative: Carpmaels & Ransford

(56) References cited:
- US-A- 5 220 216
- PATENT ABSTRACTS OF JAPAN vol. 017, no. 359 (E-1395), 7 July 1993 (1993-07-07) & JP 05 055891 A (SEIKO EPSON CORP), 5 March 1993 (1993-03-05)
- PATENT ABSTRACTS OF JAPAN vol. 015, no. 315 (E-1099), 12 August 1991 (1991-08-12) & JP 03 117020 A (NEC CORP), 17 May 1991 (1991-05-17)
- PATENT ABSTRACTS OF JAPAN vol. 017, no. 134 (E-1334) 19 March 1993 & JP 04 306 017 A (MITSUBISHI ELECTRIC CORP) 28 October 1992

## Description

### FIELD OF THE INVENTION

The present invention relates to clock drivers and clock trees and, more specifically, to providing clock drivers and clock trees with programmable output characteristics.

### BACKGROUND OF THE INVENTION

In application specific integrated circuits (ASICs) and in other integrated circuits a clock signal may be distributed to thousands and perhaps tens of thousands of "locations." This distribution is conventionally achieved using clock trees and a typical clock tree consists of a plurality of buffer drivers arranged in stages with each stage having more outputs than inputs.

If a representative clock tree provides a 1:10 input to output ratio at each stage and has four stages, then the number of clock signal lines increases from 1 to 10, 10 to 100, 100 to 1,000 and 1,000 to 10,000 at stages 1-4, respectively. This staged increase in the number of signal lines provides a like increase in the number of simultaneous or nearly simultaneous clock signal transitions (e.g., from positive to negative and vice versa). Since clock signal transitions are a source of electromagnetic interference (EMI), large numbers of simultaneous clock signal transitions produce an undesirably large amount of EMI. This problem is further exacerbated as semiconductor technologies advance. Reduction in integrated circuit feature size increases the density of clock signal transitions per unit area. Furthermore, faster operating speeds tend to increase a circuit's sensitivity to EMI and other parasitics.

Patent Abstracts of Japan, Vol. 017, No. 359 (E-1395) & JP 05 055891 A, Patent Abstracts of Japan, Vol. 015, No. 315 (E-1099) & JP 03 117020 A and US 5 220 216 A each describe a single circuit comprising a plurality of pairs of transistors which are selectively enabled by logic signals so as to control the level of an output of the circuit.

Patent Abstracts of Japan, Vol. 017, No. 137 (E-1335) & JP 04 306 917 A describes a distributor provided with a plurality of clock drivers in a clock tree. The clock signals are combined in a logic gate, the output of which is supplied to a synchronising circuit.

It would be desirable:
(a) to provide a clock signal driver that permits selection of the shape of the output clock signal;
(b) to provide a clock signal driver wherein the amount of signal modification is programmable; and
(c) to provide a clock driver with selectable resistive values so that when those values are combined with load capacitance values, a selectable time constant is effectively achieved.

### SUMMARY OF THE INVENTION

In accordance with the present invention there is provided a clock signal driving apparatus as defined in claim 1.

The resistive device may be configured as a MOS transistor and the modification logic selected so as to enable or disable the MOS transistor.

The attainment of the foregoing and related advantages and features of the invention should be more readily apparent to those skilled in the art, after review of the following more detailed description of the invention taken together with the drawings.

### BRIEF DESCRIPTION OF THE DRAWINGS

Fig. 1 is a schematic diagram of a clock tree in accordance with the present invention.
Fig. 2 is a schematic block diagram of a clock signal driver circuit in accordance with the present invention.
Fig. 3 is a schematic block diagram of selection logic 231 for use in circuit 100 of Fig. 2 in accordance with the present invention.

### DETAILED DESCRIPTION

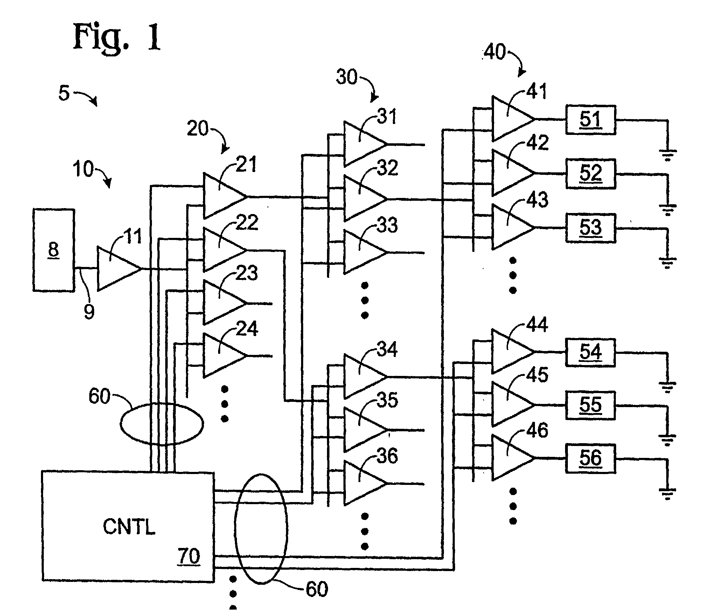

Referring to Fig. 1, a schematic block diagram of a clock tree in accordance with the present invention is shown. The embodiment of Fig. 1 illustrates a representative clock tree having four stages, though it should be recognized that the clock tree may have more or less stages without departing from the present invention.

Clock tree 5 includes a clock source 8 which is conventionally a crystal oscillator or the like. A clock signal output from source 8 is propagated over line 9 to a first stage (10) buffer driver 11 (hereinafter referred to as a "driver"). The output of driver 11 is delivered to a plurality of second stage (20) drivers, four of which are shown (21-24). While four are shown, it should be recognized that this number can be as large or as small as permitted by known fanout or load determining factors such as impedance, conductor length, etc. The outputs of the second stage drivers are in turn coupled to the input of third stage (30) drivers 31-36 and the third stage drivers are similarly coupled to fourth stage (40) drivers 41-46. In the illustrated embodiment, clock signals output from the fourth stage are delivered to their destination (functional logic) that is indicated by loads 51-56. It should be recognized that the number of stages and the number of drivers within each stage is dependent upon the number of locations to which the clock signal need be delivered and the fanout ability of each driver, etc., as is generally known.

In accordance with the present invention, some or all of the drivers (11, 21-24, 31-36, 41-46) are configured such that they permit programmable shaping of their output clock signal. The drivers may be controlled individually, in sets (e.g., drivers 31-33, 34-36, 41-43 and 44-46 may each be considered a "set" of drivers), in stages or as otherwise desired by a circuit designer. It should be recognized that the provision of programmable clock signal shaping may be more critical in the latter stages of the clock tree (such as the third and fourth stages of Fig. 1) because the number of nearly simultaneous clock signal transitions is increased at these stages. It should also be recognized that staggering the timing or shape of the clock signals output from the second stage drivers 21-24 creates staggered clock signal transitions throughout clock tree 10.

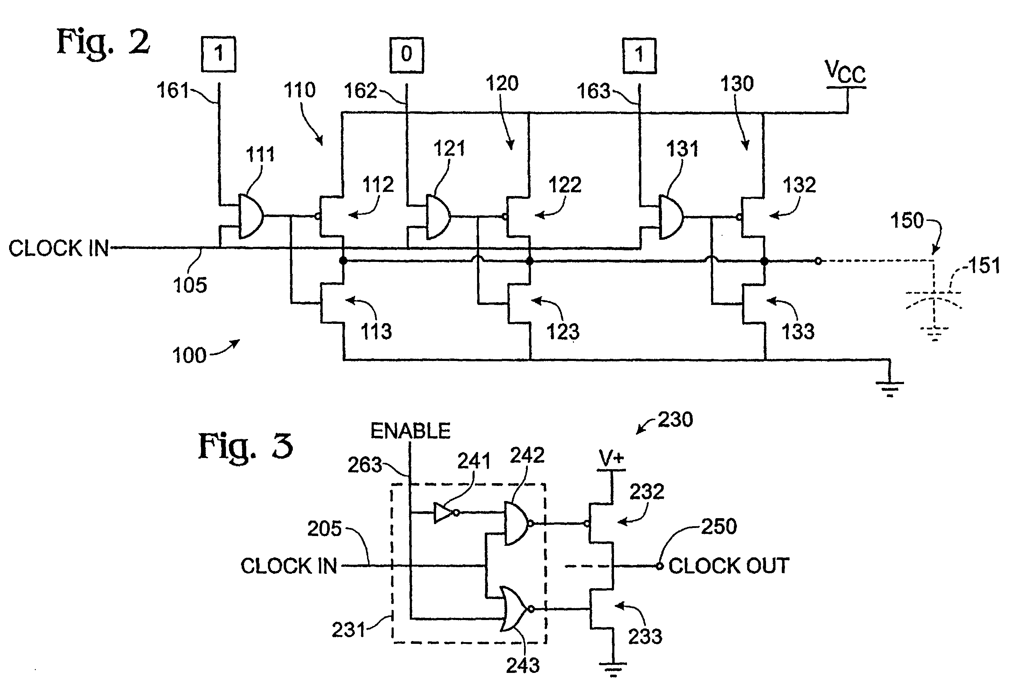

The ability to program output clock signals is a function of the design of the drivers (as discussed in more detail below with reference to Fig. 2) and the delivery of appropriate control signals. While control signals may be delivered in many known manners (including tying inputs to a particular logic state, etc.), in a preferred embodiment, select lines 60 are provided that propagate signals from control logic 70. Control logic 70 preferably includes one or more data registers and a processor that writes control/select bits to the data registers. The data registers hold the value of a clock driver selection signal as discussed below.

Referring to Fig. 2, a schematic block diagram of a clock signal driver circuit 100 in accordance with the present invention is shown. Each of the drivers 11, 21-24, 31-36, and 41-46 may be configured to include driver circuit 100. It is not necessary to configure driver 11 with programmable output characteristics if it is the only first stage buffer from source 8. It is preferred, however, that the other drivers or sets or subsets thereof are configured to provide programmable output characteristics.

Fig. 2 illustrates that driver circuit 100 has a plurality of CMOS transistors 110,120,130. Appropriate combinational logic, such as an AND gate or the like (111, 121,131), is coupled to the gate of the PMOS and NMOS transistors 112,122,132 and 113,123,133, respectively, to control current flow therethrough. An input clock signal is delivered on line 105 to each of the AND gates. Another input to each of the AND gates is a select line such as one of the select lines 60 of Fig. 1. Each of select lines 60 preferably includes a plurality of individual transistor control lines. Three control lines 161-163 are shown in Fig. 2. A three bit representative selection signal of "101" is indicated as being delivered by these lines. The value 101 (or other value delivered by the control lines) is stored, for example, in the data register of control logic 70.

The output of each CMOS transistor is coupled to a common output line to which load 150 is coupled. The circuit or other componentry driven by driver circuit 100 is represented generally by load 150. Each load has an appreciable capacitance associated therewith and this capacitance is represented in phantom lines by capacitor 151.

While clock signals propagating through drivers are often illustrated as having a crisp square wave form, in reality these clock signals have rounded corners or, from another perspective, curved or sloping transitions. The rounded corners and curved transitions are a result, at least in part, of the time constant created by inherent or parasitic resistance in the clock signals current path and capacitance 151 in the load.

Circuit 100 permits selection of the value of resistance in the clock signal's current path (within the driver) and this selected value in combination with the capacitance of the load creates a time constant that determines the shape of the output clock signal transitions. The provision of selectable time constants permits a circuit designer to soften and/or separate clock signal transitions. The softened and/or spaced clock signal transitions result in significantly reduced EMI and related noise.

Referring more specifically to the embodiment of Fig. 2, select/control lines 161-163 permit a user to selectively enable CMOS transistors 110,120,130. Each enabled CMOS transistor effectively functions as a voltage divider with the necessary resistive components being provided primarily by the surface area dependent resistance value of the gate(s). Accordingly, if the three CMOS transistors have the same size gates (i.e., the same resistive values), then a designer may select between three possible resistive values, those values provided by enabling one, two or three of the transistors. Alternatively, the CMOS transistors may be configured such that one or more have differently sized gates. For example, if each of transistors 110,120,130 have a different sized gate, then a designer may select from amongst seven possible resistive values for circuit 100. These include the following enabled CMOS transistor scenarios (which are followed by their selection signal as propagated on lines 161-163 in parentheses): 110 (100), 120 (010), 130 (001), 110+120 (110), 110+130 (101), 120+130 (011) and 110+120+130 (111).

It should also be recognized that, while the present invention is shown in Figs. 2-3 in a CMOS embodiment, it may also be implemented in an NMOS or PMOS setting, either using selectable NMOS or PMOS transistors arranged generally as discussed above or selectable NMOS or PMOS transistors in combination with resistors formed in the semiconductor material.

Referring to Fig. 3, a schematic block diagram of selection logic 231 for use in circuit 100 of Fig. 2 in accordance with the present invention is shown. Logic 231 essentially takes the place of any or all of the AND gates of circuit 100. In Fig. 3, logic 231 is described as though it replaces gate 131, though it may understandably also replace gates 111,121.

Logic 231 provides an inverter 241, a NAND gate 242 and a NOR gate 243. The input clock signal on line 205 is propagated to the NAND and NOR gates. The select signal is propagated via line 263 to the NOR gate and through invertor 241 to the NAND gate. Logic 231 permits CMOS transistor 230 (analogous to CMOS transistor 130) to be tri-stated such that a signal may be driven into the clock signal output 250.

While the invention has been described in connection with specific embodiments thereof, it will be understood that it is capable of further modification, within the scope of the appended claims.

## Claims

1. A clock signal driving apparatus comprising:
a plurality of first driver circuits (21-24; 100) each having an input (105), for receiving the same input clock signal, and an output;
a corresponding plurality of groups of second driver circuits (31-36; 100) each of said second driver circuits (31-36; 100) having an input (105) and an output;
the output of each of the first driver circuits (21-24; 100) being connected to each of the respective inputs of a respective group of second driver circuits (31-36; 100);
each of said first and said second driver circuits (21-24, 31-36; 100) comprising:
a plurality of selectable semiconductor resistive elements (112, 113, 122, 123, 132, 133; 232, 233); and
selection logic (70; 111, 121, 131; 231) for applying logic signals to the resistive elements (112, 113, 122, 123, 132, 133; 232, 233) to select one or more of said resistive elements and thereby to create a signal at the driver circuit output which represents the signal at the driver circuit input (105) modified to an extent determined by the selected resistive elements;
thereby to generate a plurality of clock signals at the outputs of the second driver circuits (31-36; 100) each representing the input clock signal modified by a respective selected amount.

2. A clock signal driving apparatus as claimed in claim 1, wherein said selection logic (70; 111, 121, 131; 231) is arranged to receive the signal which is present at the respective driver circuit input (105), together with a respective resistive element select signal (161, 162, 163; 263) for each resistive element and to generate respective enable signals which are supplied to said resistive elements (112, 113, 122, 123; 132, 133; 232, 233).

3. A clock signal driving apparatus as claimed in claim 1 or claim 2, wherein said plurality of selectable semiconductor resistive elements (112, 113, 122, 123, 132, 133; 232, 233) within each of said driver circuits (21-24, 31-36; 100) comprises a plurality of pairs of MOS transistors (110, 120, 130; 230) each pair being connected in series between a voltage supply and ground and defining an output at the junction of the two transistors within each pair, the outputs from each pair of transistors within each driver circuit (21-24, 31-36; 100) being connected together to form the driver circuit output.

4. A clock signal driving apparatus as claimed in claim 3, wherein said selection logic (70; 111, 121, 131; 231) serves to enable selectively one or more of said transistors (112, 113, 122, 123; 132, 133; 232, 233).

5. A clock signal driving apparatus as claimed in any preceding claim, wherein said selection logic comprises tri-state logic (231) for disabling one or more of said resistive elements (232, 233).

## Patentansprüche

1. Eine Taktsignal-Treibervorrichtung, die folgende Merkmale aufweist:
eine Mehrzahl von ersten Treiberschaltungen (21-24; 100), die jeweils einen Eingang (105) zum Empfangen desselben Eingangstaktsignals und einen Ausgang aufweisen;
eine entsprechende Mehrzahl von Gruppen von zweiten Treiberschaltungen (31-36; 100), wobei jede der zweiten Treiberschaltungen (31-36; 100) einen Eingang (105) und einen Ausgang aufweist;
wobei der Ausgang jeder der ersten Treiberschaltungen (21-24; 100) mit jedem der jeweiligen Eingänge einer jeweiligen Gruppe von zweiten Treiberschaltungen (31-36; 100) verbunden ist;
wobei jede der ersten und der zweiten Treiberschaltungen (21-24, 31-36; 100) folgende Merkmale aufweist:
eine Mehrzahl von auswählbaren Halbleiter-Widerstandselementen (112, 113, 122, 123, 132, 133; 232, 233); und
eine Auswahllogik (70; 111, 121, 131; 231) zum Anlegen von logischen Signalen an die Widerstandselemente (112, 113, 122, 123, 132, 133; 232, 233), um eines oder mehrere der Widerstandselemente auszuwählen und dadurch an dem Treiberschaltungsausgang ein Signal zu erzeugen, das das Signal an dem Treiberschaltungseingang (105) darstellt, das in einem durch die ausgewählten Widerstandselemente bestimmten Ausmaß modifiziert ist;
um dadurch eine Mehrzahl von Taktsignalen an den Ausgängen der zweiten Treiberschaltungen (31-36; 100) zu erzeugen, die jeweils das um ein jeweiliges ausgewähltes Ausmaß modifizierte Eingangstaktsignal darstellen.

2. Eine Taktsignal-Treibervorrichtung gemäß Anspruch 1, bei der die Auswahllogik (70; 111, 121, 131; 231) angeordnet ist, um das Signal, das an dem jeweiligen Treiberschaltungseingang (105) vorhanden ist, zusammen mit einem jeweiligen Widerstandselement-Auswahlsignal (161, 162, 163; 263) für jedes Widerstandselement zu empfangen und um jeweilige Aktivierungssignale zu erzeugen, die den Widerstandselementen (112, 113, 122, 123, 132, 133; 232, 233) geliefert werden.

3. Eine Taktsignal-Treibervorrichtung gemäß Anspruch 1 oder 2, bei der die Mehrzahl von auswählbaren Halbleiter-Widerstandselementen (112, 113, 122, 123, 132, 133; 232, 233) in jeder der Treiberschaltungen (21-24, 31-36; 100) eine Mehrzahl von Paaren von MOS-Transistoren (110, 120, 130; 230) aufweist, wobei jedes Paar zwischen eine Spannungsversorgung und Masse in Reihe geschaltet ist und einen Ausgang an der Verbindungsstelle der beiden Transistoren in jedem Paar definiert, wobei die Ausgänge von jedem Paar von Transistoren in jeder Treiberschaltung (21-24, 31-36; 100) miteinander verbunden sind, um den Treiberschaltungsausgang zu bilden.

4. Eine Taktsignal-Treibervorrichtung gemäß Anspruch 3, bei der die Auswahllogik (70; 111, 121, 131; 231) dazu dient, einen oder mehrere der Transistoren (112, 113, 122, 123, 132, 133; 232, 233) selektiv zu aktivieren.

5. Eine Taktsignal-Treiberschaltung gemäß einem der vorhergehenden Ansprüche, bei der die Auswahllogik eine Dreizustandslogik (231) zum Deaktivieren eines oder mehrerer der Widerstandselemente (232, 233) aufweist.

## Revendications

1. Dispositif de commande de signal d'horloge comprenant :
une pluralité de premiers circuits de commande (21 à 24 ; 100) ayant chacun une entrée (105) pour recevoir le même signal d'horloge d'entrée et une sortie ;
une pluralité correspondante de groupes de seconds circuits de commande (31 à 36 ; 100) chacun desdits seconds circuit de commande (31 à 36 ; 100) ayant une entrée (105) et une sortie ;
la sortie de chacun des premiers circuits de commande (21 à 24 ; 100) étant connectée à chacune des entrées respectives d'un groupe respectif de seconds circuits de commande (31 à 36 ; 100) ;
chacun desdits premiers et desdits seconds circuits de commande (21 à 24, 31 à 36 ; 100) comprenant
une pluralité d'éléments résistifs à semiconducteur pouvant être sélectionnés (112, 113, 122, 123, 132, 133 ; 232, 233) ; et
un circuit logique de sélection (70 ; 111, 121, 131, 231) pour appliquer des signaux logiques aux éléments résistifs (112, 113, 122, 123, 132, 133 ; 232, 233) pour sélectionner un ou plusieurs desdits éléments résistifs et de manière à créer ainsi un signal au niveau de la sortie du circuit de commande qui représente le signal à l'entrée du circuit de commande (105), modifié dans une mesure déterminée par les éléments résistifs sélectionnés ;
de façon à produire une pluralité de signaux d'horloge sur les sorties des seconds circuits de commande (31 à 36 ; 100) représentant chacun le signal d'horloge d'entrée modifié d'une quantité sélectionnée respective.

2. Dispositif de commande de signal d'horloge selon la revendication 1, dans lequel ledit circuit logique de sélection (70 ; 111, 121, 131 ; 231) est agencé pour recevoir le signal qui est présent à l'entrée du circuit de commande respectif (105), ainsi qu'un signal de sélection d'élément résistif respectif (161, 162, 163 ; 263) pour chaque élément résistif et pour produire des signaux d'activation respectifs qui sont fournis auxdits éléments résistifs (112, 113, 122, 123 ; 132, 133 ; 232, 233).

3. Dispositif de commande de signal d'horloge selon la revendication 1 ou la revendication 2, dans lequel ladite pluralité d'éléments résistifs à semiconducteur pouvant être sélectionnés (112, 113, 122, 123 ; 132, 133 ; 232, 233) à l'intérieur de chacun desdits circuits de commande (21 à 24, 31 à 36, 100) comprend une pluralité de paires de transistors MOS (110, 120, 130 ; 230) chaque paire étant connectée en série entre une tension d'alimentation et la masse et définissant une sortie à la jonction des deux transistors dans chaque paire, les sorties de chaque paire de transistors dans chaque circuit de commande (21 à 24, 31 à 36 ; 100) étant connectées ensemble de manière à constituer la sortie du circuit de commande.

4. Dispositif de commande de signal d'horloge selon la revendication 3, dans lequel ledit circuit logique de sélection (70 ; 111, 121, 131 ; 231) sert à activer de façon sélective un ou plusieurs desdits transistors (112, 113, 122, 123 ; 132, 133 ; 232, 233).

5. Dispositif de commande de signal d'horloge selon l'une quelconque des revendications précédentes, dans lequel ledit circuit logique de sélection comprend un circuit logique à trois états (231) pour désactiver un ou plusieurs desdits éléments résistifs (232, 233).
